# EUROPÄISCHE PATENTSCHRIFT

(11) **EP 0 500 973 B1**
(45) Veröffentlichungstag und Bekanntmachung des Hinweises auf die Patenterteilung: **06.05.1999**
(21) Anmeldenummer: 91102757.1
(22) Anmeldetag: 25.02.1991
(51) Int. Cl.: G06F 9/445, G06F 12/06, G06F 15/78, G11C 8/00

(54) **EEPROM und Verfahren zum Ändern einer Initialisierungsroutine im EEPROM**
EEPROM and method for altering a bootstrap routine in the EEPROM
EEPROM et méthode pour changer une routine d'initialisation dans la EEPROM

(43) Veröffentlichungstag der Anmeldung: 02.09.1992
(73) Patentinhaber: SIEMENS AKTIENGESELLSCHAFT, 80333 München (DE)
(72) Erfinder: Lang, Georg, Dipl.-Ing. (FH), W-8458 Sulzbach-Rosenberg (DE)

(56) Entgegenhaltungen:
- DE-A- 3 815 071
- US-A- 4 430 704
- ELECTRONIC ENGINEERING, Band 60, Nr. 742, Oktober 1988, Seiten 75-76,79-80, Woolwich, London, GB; R. SOJA et al.: "Single chip MCU EEPROM programming using bootstrap techniques"
- ELEKTROTECHNIK, Band 71, Nr. 6, 29. September 1989, Seiten 94-100,104, Würzburg, DE; M.C. MARKOWITZ: "Nonvolatile memories"
- ELECTRO, Band 11/4, Mai 1984, Seiten 1-5, New York, US; S. GROSSMAN: "Revolutionary advances in EEPROM features"

## Beschreibung

Die Erfindung betrifft einen elektrisch überschreibbaren Festwertspeicher nach dem Oberbegriff des Anspruchs 1 sowie ein Verfahren zum Ändern der Initialisierungsroutine.

Derartige Festwertspeicher sind aus "Electronic Engineering", Band 60, Nr. 742, Seiten 75 bis 90 bekannt. In ihnen ist beispielsweise die Initialisierungsroutine eines Rechengeräts abgespeichert.

Aufgabe der vorliegenden Erfindung ist es, eine Möglichkeit zu einer schnellen, einfachen, billigen und sicheren Erneuerung der Initialisierungsroutine zu schaffen. Die Erneuerung soll dabei insbesondere so einfach und sicher sein, daß sie auch vom Anwender durchgeführt werden kann.

Die Aufgabe wird durch die kennzeichnenden Merkmale des Anspruchs 1 gelöst.

Dadurch wird erreicht, daß die Initialisierungsroutine durch ein Verfahren nach Anspruch 8 abgeändert werden kann.

Wenn Initialisierungsroutine und Betriebssystem im selben Festwertspeicher abgespeichert sind, weist der Festwertspeicher mit Vorteil mindestens einen weiteren getrennt schreib- und lesbaren, gegebenenfalls auch getrennt löschbaren Speicherbereich auf, so daß bei einer Betriebssystemänderung, die erheblich häufiger vorkommt als eine Änderung der Initialisierungsroutine, letztere nicht versehentlich überschrieben werden kann.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Es zeigen:
FIG 1 ein Blockschaltbild eines Automatisierungsgeräts,
FIG 2 ein Blockschaltbild eines PC's,
FIG 3 ein Blockschaltbild eines Festwertspeichers,
FIG 4 den inneren Aufbau des Festwertspeichers und
FIG 5 ein Ablaufdiagramm eines Änderungsvorgangs.

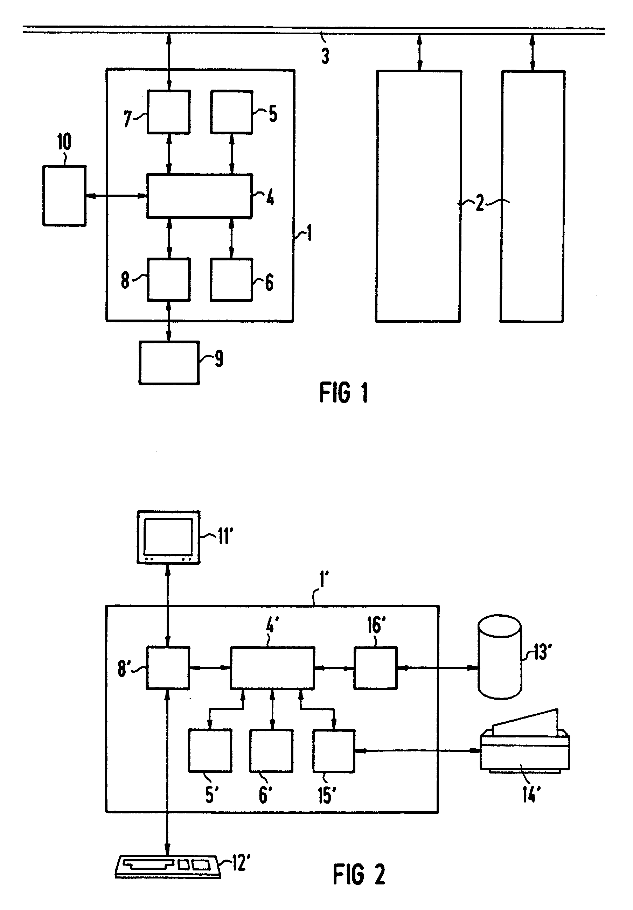

Gemäß FIG 1 besteht ein modulares Automatisierungsgerät aus mindestens einer Zentraleinheit 1 sowie mehreren Peripheriebaugruppen 2, die über einen Bus 3 miteinander verbunden sind. Die Zentraleinheit 1 weist einen Prozessor 4, einen Schreib-Lese-Speicher 5 für das abzuarbeitende Programm sowie einen Festwertspeicher 6 für die Initialisierungsroutine und das Betriebssystem des Automatisierungsgeräts auf. Weiterhin verfügt die Zentraleinheit 1 über zwei Prozessoren 7, 8, die für den Datenverkehr mit den Peripheriebaugruppen 2 bzw. dem Programmiergerät 9 zuständig sind. Außerdem kann mit der Zentraleinheit 1 noch ein Speichermodul 10 verbunden sein, in dem beispielsweise ein Anwenderprogramm abgespeichert sein kann.

Der Festwertspeicher 6 ist als elektrisch überschreibbarer Festwertspeicher ausgebildet, der über einen elektrischen Impuls geschlossen schnell löschbar ist. Der Prozessor 4 ist beispielsweise ein 68000 der Firma Motorola. Dieser Prozessor greift nach einem RESET-Befehl als erstes auf die Adresse 0000₁₆ zu.

FIG 2 zeigt den prinzipell ähnlichen Aufbau eines PCs 1'. Ähnlich wie das Automatisierungsgerät 1 besteht der PC 1' im wesentlichen aus einem Prozessor 4', einem Schreib-Lese-Speicher 5', einem Festwertspeicher 6' für Initialisierungsroutine und Betriebssystem sowie einem Prozessor 8' zur Kommunikation mit einer Tastatur 12' und einem Monitor 11'. Weiterhin sind an den PC 1' eine Speichereinheit 13', z.B. ein Diskettenlaufwerk, sowie ein Drucker 14' angeschlossen, die über die Prozessoren 15', 16' mit dem Prozessor 4' kommunizieren.

Auch hier ist der Festwertspeicher 6' ein elektrisch überschreibbarer Festwertspeicher, der über einen elektrischen Impuls geschlossen schnell löschbar ist. Der Prozessor 4' ist diesmal z.B. ein 8086 der Firma INTEL, der nach einem RESET als erstes auf den Befehl mit der Adresse FFFF0₁₆ zugreift.

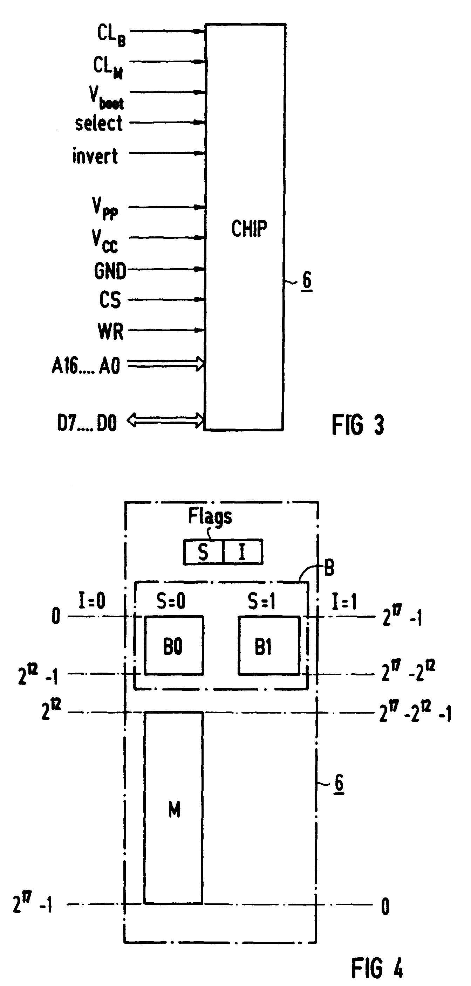

FIG 3 zeigt die Anschlußbelegung des Festwertspeichers 6 (bzw. 6'). Gemäß FIG 3 weist der Festwertspeicher 6 folgende Anschlüsse auf:
- Mehrere Anschlüsse D7...D0 zum Übertragen von Datensignalen,
- mehrere Anschlüsse A16...A0 zum Anlegen von Adreßsignalen,
- Anschlüsse zum Anlegen von Steuersignalen V_{boot}, select, invert, V_{PP}, V_{CC}, GND, CS, WR, CL_{B}, CL_{M}.

Dabei kommt den Steuersignalen folgende Bedeutung zu:
- Bei Vorliegen des Signals WR und gleichzeitigem Vorliegen mindestens einer der Programmierspannungen V_{PP} oder V_{boot} werden Daten in den Speicher 6 geschrieben.
- An den Speicher 6 angelegte Signale zeigen nur dann Wirkung, wenn über das Steuersignal CS der Chip 6 selektiert wurde.
- Die Signale V_{CC} und GND dienen der Spannungsversorgung und dem Masseanschluß.
- Bei Anliegen des Signals invert bzw. select und gleichzeitigem Anliegen der Signale V_{boot} und WR wird eine Zustandsgröße S bzw. I geschrieben. Ohne das Signal WR werden die Zustandsgrößen S bzw. I über die Anschlüsse select bzw. invert nur gelesen bzw. ein angelegtes Signal bewirkt kein Uberschreiben. Die Bedeutung der Zustandsgrößen S und I wird in Verbindung mit FIG 4 noch ausführlich erläutert werden.

Gemäß FIG 4 weist der Festwertspeicher 6 zwei Speicherbereiche B und M auf, wobei der Speicherbereich B in zwei Teil-Speicherbereiche B0, B1 aufgeteilt ist, die auf gleichen Adressen liegen.

Im Festwertspeicher 6 sind zumindest die Prozessor-Initialisierungsroutine, die Systemtestroutine und der Urlader des Systems abgespeichert, mit Vorteil auch das Grund-Ein-/Ausgabe-System (BIOS) sowie das gesamte Betriebssystem abgespeichert. Im Speicherbereich B0 bzw. B1 ist dabei zumindest die Prozessor-Initialisierungsroutine abgespeichert, d.h. die ersten Informationen, auf die der Prozessor 4 bei einer Systeminitialisierung (Reset) zugreift. Die Informationen können dabei Prozessordaten, z.B. Pointer, oder Befehle sein. Mit Vorteil sind im Speicherbereich 80 bzw. B1 auch die Systemtestroutine und der Urlader abgespeichert. Im Speicherbereich M sind die Systemtestroutine und der Urlader abgespeichert, soweit sie nicht bereits im Speicherbereich B0 bzw. B1 abgespeichert sind. Weiterhin sind mit Vorteil im Speicherbereich M das Grund-Ein-/Ausgabe-System (BIOS) sowie das restliche Betriebssystem abgespeichert.

Wie aus FIG 4 ersichtlich ist, ist den Speicherbereichen B0, B1 der Adreßbereich von 0 bis 2¹²-1 zugeordnet, während dem Speicherbereich M der Adreßbereich ab 2¹² zugewiesen ist. Wenn I gesetzt ist, d.h. I gleich 1 ist, werden die Adreßsignale invertiert. Der Grund dafür ist, daß manche Prozessoren bei einem Reset die Initialisierungsroutine im hohen Adreßbereich suchen, während andere sie im niedrigen Adreßbereich suchen. Wenn - wie hier durch die Zustandsgröße I - die Möglichkeit besteht, die Speicherbereiche B0, B1 im Adreßbereich scheinbar zu verschieben, kann der Festwertspeicher 6 bei beiden Prozessoren verwendet werden. Es werden also Kosten für die Chipentwicklung eingespart.

Um ein ordnungsgemäßes Hochfahren eines Systems zu ermöglichen, ist es nicht nötig, daß exakt die richtige Adresse getroffen wird. Der erste Zugriff auf den Festwertspeicher 1 muß nur in den richtigen Bereich treffen. Daher ist es auch ausreichend, wenn nur die signifikantesten Adreßsignale, z.B. die Adreßsignale A16...A12 invertiert werden.

Mit der Zustandsgröße S wird ausgewählt, ob bei einem Reset der Datenverarbeitungsanlage auf den Speicherbereich B0 oder auf den Speicherbereich B1 zugegriffen wird.

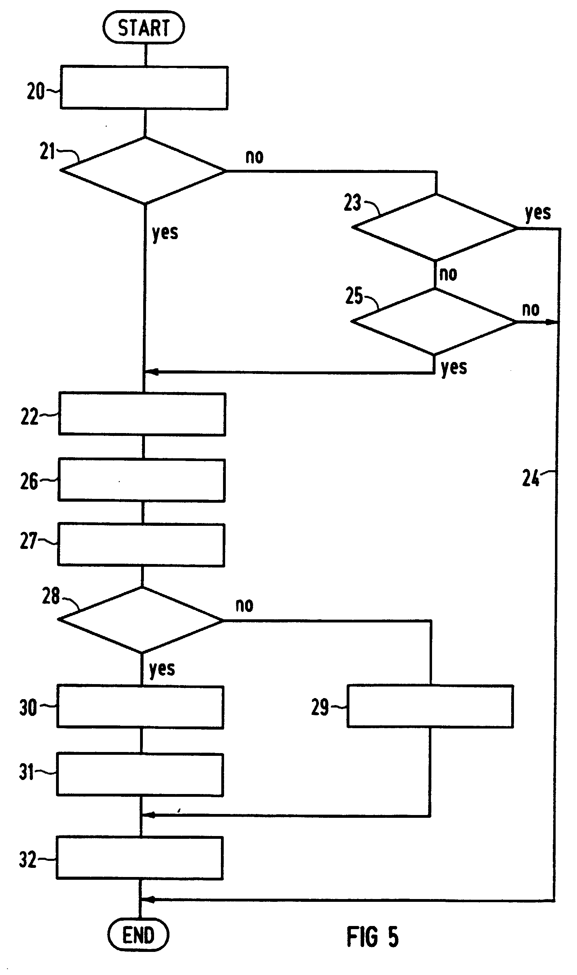

Die Speicherbereiche M, B0, B1 und Flags sind in Flash-Technologie hergestellt. Das heißt, daß der Speicherbereich M durch gleichzeitiges Anlegen der Steuersignale V_{PP} und CL_{M} gelöscht werden kann, während der jeweils inaktive Speicherbereich B0 oder B1 durch gleichzeitiges Anlegen der Steuersignale V_{boot} und CL_{B} gelöscht werden kann. Für die Erläuterung der FIG 5 wird angenommen, daß die Zustandsgröße S den Wert 0 hat, so daß bei einem Reset auf den Speicherbereich B0 zugegriffen wird.

Zur Änderung der Initialisierungsroutine und/oder des Betriebssystem erhält der Anwender vom Hersteller seines Rechengeräts einen Datenträger, üblicherweise eine Diskette, auf der die neue Version der Initialisierungsroutine bzw. des Betriebssystem abgespeichert ist. Im folgenden wird die Vorgehensweise beim Abändern der Initialisierungsroutine beschrieben. Das im folgenden Gesagte ist jedoch auch auf die Abänderung des Betriebssystems anwendbar.

Wenn das Rechengerät ein Automatisierungsgerät ist, wird die Diskette in das Diskettenlaufwerk eines Programmiergeräts 9 eingelegt und vom Benutzer der Befehl zum Ändern der Initalisierungsroutine eingegeben. Wenn das Programmiergerät 9 an die Zentraleinheit 1 angeschlossen ist, wird das Überschreiben der Initialisierungsroutine sofort ausgeführt. Anderenfalls muß der Anwender mit dem Programmiergerät 9 ein nicht dargestelltes Speichermodul programmieren, das nach dem Programmieren in den (ebenfalls nicht dargestellten) Modulschacht des Automatisierungsgeräts 1 eingeschoben wird. Nach dem Einschieben des Speichermoduls und dem Anfordern des Änderungsvorganges selbst braucht sich der Anwender in der Regel um nichts mehr zu kümmern. Der weitere Vorgang wird vom Anwender verdeckt vom Automatisierungsgerät 1 durchgeführt.

Wie FIG 5 zeigt, wird im Funktionsbaustein 20 zunächst die Kennung der aktuell abgespeicherten Initialisierungsroutine gelesen und mit der Kennung der abzuspeichernden Initialisierungsroutine verglichen. Die Kennung kann z.B. in Versionsnummern für Automatisierungsgerät 1 und Initialisierungsroutine bestehen. Wenn der vom Funktionsbaustein 21 durchgeführte Vergleich der Kennungen das Ergebnis liefert, daß die abzuspeichernde Initialisierungsroutine für das Automatisierungsgerät 1 geeignet ist und daß die abzuspeichernde Initialisierungsroutine eine höhere Versionsnummer als die abgespeicherte Initialisierungsroutine hat, wird direkt zum Funktionsbaustein 22 verzweigt. Anderenfalls wird im Funktionsbaustein 23 abgefragt, ob die abzuspeichernde Initialisierungsroutine für das Automatisierungsgerät 1 geeignet ist. Wenn nicht, wird das Änderungsprogramm über den Zweig 24 verlassen. Wenn die abzuspeichernde Initialisierungsroutine für das Automatisierungsgerät 1 geeignet ist, muß also jetzt die Versionsnummer der abzuspeichernden Initialisierungsroutine kleiner oder gleich der Versionsnummer der abgespeicherten Initialisierungsroutine sein. In diesem Falle wird vom Funktionsbaustein 25 der Anwender gefragt, ob das Änderungsprogramm trotzdem ausgeführt werden soll. Wenn der Anwender dies verneint, wird die Änderungsroutine ebenfalls über den Zweig 24 verlassen. Anderenfalls wird die Änderungsroutine ausgeführt.

Die Änderungsroutine besteht gemäß FIG 5 aus den Funktionsbausteinen 22 sowie 26 bis 32. Im Funktionsbaustein 22 wird zunächst die Programmierspannung V_{boot} an den Festwertspeicher 6 angelegt. Solange die Spannung V_{boot} anliegt, wird auf den Speicherbereich B0 überhaupt nicht zugegriffen, während auf den Speicherbereich B1 sowohl lesend als auch schreibend als auch löschend zugegriffen werden kann.

Sodann wird in den Funktionsbausteinen 26 und 27 der Speicherbereich B1 gelöscht und neu beschrieben. Sodann wird im Funktionsbaustein 28 abgeprüft, ob die Programmierung des Speicherbereichs B1 korrekt war. Wenn nicht, wird zum Funktionsbaustein 29 verzweigt, der eine Fehlermeldung an den Anwender ausgibt. In diesem Falle wird der Wert der Zustandsgröße S nicht geändert.

Ansonsten wird im Funktionsbaustein 30 der Wert der Zustandsgröße S invertiert und der invertierte Wert in den Festwertspeicher 6 zurückgeschrieben. Dadurch, daß der Wert der Zustandsgröße S sich jetzt geändert hat, wird ab sofort bei einem Reset auf den Speicherbereich B1 und bei Anlegen der Programmierspannung V_{boot} auf den Speicherbereich 80 zugegriffen. Auch die erfolgreiche Neuprogrammierung des Speicherbereichs B1 wird über den Funktionsbaustein 31 dem Anwender gemeldet.

Als nächstes wird im Funktionsbaustein 32 die Programmierspannung V_{boot} wider abgeschaltet. Damit ist die Neuprogrammierung des Speicherbereichs B1 vollendet. Bei einem Reset werden nun automatisch nicht mehr die im Speicherbereich B0 abgespeicherten Programme, sondern nur noch die im Speicherbereich B1 abgespeicherten Programme ausgeführt.

Falls sich wider Erwarten nach dem Umschalten auf den Speicherbereich B1 herausstellen sollte, daß das nunmehr im Speicherbereich B1 abgespeicherte Programm doch noch fehlerhaft ist, kann durch Ändern nur der Zustandsgröße S wieder auf die alten, lauffähigen Programme, die im Speicherbereich 80 abgespeichert sind, zugegriffen werden. Diese Änderung kann, weil sie nicht umfangreich ist, nötigenfalls von Hand durchgeführt werden.

Der gesamte, in Zusammenhang mit FIG 5 beschriebene Vorgang läuft mit Ausnahme des Funktionsbausteins 25 ohne aktive Mitwirkung des Anwenders ab, kann also verdeckt erfolgen.

Wenn der Festwertspeicher 6 nicht geschlossen löschbar ist, sondern die Speicherzellen einzeln gelöscht und überschrieben werden müssen, besteht eine weitere Möglichkeit zur Absicherung des Rechengeräts vor unkontrolliertem Verhalten darin, das
- zunächst der erste Befehl, auf den bei einer Initialisierung zugegriffen wird, derart abgeändert wird, daß bei einem Initialisierungsversuch als nächstes auf Befehle zugegriffen wird, die das Rechengerät in einen sicheren Zustand überführen, z.B. einen Systemhalt,
- sodann die anderen Befehle und Daten der Initialisierungsroutine abgeändert werden und
- schließlich der erste Befehl wieder rückgeändert wird, so daß die Initialisierungsroutine wieder ausführbar ist.

Abschließend sei darauf hingewiesen, daß das Steuersignal, mit dem die Programmierung des Speicherbereichs B1 ermöglicht wird, nicht notwendigerweise eine Programmierspannung sein muß, sondern ebenso auch ein normales Steuersignal sein kann. In diesem Fall ist die Programmierung des Speicherbereichs B1 nur bei Anliegen auch der Programmierspannung V_{PP} möglich.

Weiterhin sei erwähnt, daß es sowohl möglich ist, die Zustandsgrößen S, I über eigene Steuerleitungen zu lesen bzw. zu schreiben, als auch vorzusehen, auf diese Zustandsgrößen durch Anlegen vorgewählter Adreßsignale bei gleichzeitigem Anliegen der Programmierspannung V_{boot} zuzugreifen.

## Patentansprüche

1. Elektrisch überschreibbarer Festwertspeicher (6), insbesondere geschlossen schnell löschbarer Festwertspeicher (6), mit mehreren Speicherzellen, wobei jede Speicherzelle eine Adresse hat, auf Grund derer die Speicherzelle einzeln schreib- und lesbar ist, und mit Kontakten zum Anschließen von Leitungen für Adreß- (A16...A0), Daten- (D7...D0) und Steuersignale (WR, CS, GND, V_{CC}, V_{PP}, invert, select, V_{Boot}, CL_{B}, CL_{M}), wobei der Festwertspeicher (6) mindestens zwei getrennt schreib- und lesbare, gegebenenfalls auch getrennt löschbare, Speicherbereiche (B0, B1) aufweist, denen die Speicherzellen zugeordnet sind, **dadurch gekennzeichnet,** daß die Speicherzellen der mindestens zwei getrennt schreib- und lesbaren Speicherbereiche identische Adressen (0 bis 2¹²-1) haben und daß in Abhängigkeit von einer ersten Zustandsgröße (S) entweder auf die Speicherzellen eines ersten der Speicherbereiche (B0) oder auf die Speicherzellen eines zweiten der Speicherbereiche (B1) zugegegriffen werden kann.

2. Festwertspeicher (6) nach Anspruch 1, **dadurch gekennzeichnet,** daß auf die Speicherzellen des jeweils anderen Speicherbereichs (B1) nur bei Vorliegen besonderer Steuersignale (V_{Boot}) zugegriffen werden kann.

3. Festwertspeicher (6) nach Anspruch 1 oder 2, **dadurch gekennzeichnet,** daß er einen Zusatzspeicherbereich (M) zum Abspeichern weiterer Daten aufweist.

4. Festwertspeicher (6) nach Anspruch 1, 2 oder 3, **dadurch gekennzeichnet,** daß in Abhängigkeit von einer zweiten Zustandsgröße (I) mindestens eines der Adreßsignale (A16...A0) vor dem Zuordnen einer Speicherzelle zu den angelegten Adreßsignalen (A16...A0) invertiert wird.

5. Festwertspeicher (6) nach Anspruch 1, 2, 3 oder 4, **dadurch gekennzeichnet,** daß der Festwertspeicher (1) mindestens einen weiteren Speicherbereich (Flags) zum Abspeichern von den ersten und zweiten Zustandsgrößen (S,I) aufweist.

6. Festwertspeicher (6) nach Anspruch 5, **dadurch gekennzeichnet,** daß auf den weiteren Speicherbereich (Flags) nur bei Vorliegen besonderer Steuersignale (V_{boot}) zugegriffen werden kann.

7. Festwertspeicher (6) nach einem der Ansprüche 1 bis 6, **dadurch gekennzeichnet,** daß er in einem Rechengerät (1,1'), z.B. einem Automatisierungsgerät (1), zum Abspeichern zumindest der Initialisierungsroutine verwendet wird.

8. Verfahren zum Ändern der in einem Festwertspeicher (6) nach einem der Ansprüche 1 bis 7 abgespeicherten Initialisierungsroutine eines Rechengeräts, **gekennzeichnet** durch folgende Schritte:
a) an den Festwertspeicher (6) wird ein besonderes Steuersignal (V_{Boot}) angelegt, durch das ein Überschreiten des Inhalts des Festwertspeichers (6) ermöglicht wird, wobei, solange das besondere Signal anliegt, abhängig von der ersten Zustandsgröße (S) auf den ersten bzw. zweiten Speicherbereich (B0) überhaupt nicht zugegriffen wird, während auf den zweiten bzw. ersten Speicherbereich (B1) sowohl lesend als auch schreibend und gegebenenfalls auch löschend zugegriffen werden kann,
b) falls der Festwertspeicher (6) ein geschlossen schnell löschbarer Festwertspeicher (6) ist, wird an den Festwertspeicher (6) ein weiteres Steuersignal (CL_{B}) angelegt, durch das abhängig von der ersten Zustandsgröße (S) der erste oder der zweite Speicherbereich (B0, B1), in dem die Initialisierungsroutine abgespeichert ist, gelöscht wird,
c) durch das Anlegen von Adreß- (A16...A0) und Datensignalen (D7...D0) sowie gegebenenfalls weiterer Steuersignale (WR, CS) wird der Inhalt der Speicherzellen, die aufgrund der angelegten Adreßsignale (A16...A0) selektiert sind, des ersten oder des zweiten der Speicherbereiche mit einem Speicherinhalt überschrieben, der durch die angelegten Datensignale (D7...D0) bestimmt ist,
d) nach dem Uberschreiben des Speicherinhalts des Festwertspeichers (6) wird die erste Zustandsgröße (S) invertiert und das besondere Steuersignal (V_{Boot}) zurückgesetzt.

9. Verfahren nach Anspruch 8, **dadurch gekennzeichnet,**
- daß das Rechengerät (1,1') zwei Initialisierungsroutinen aufweist, von denen bei einer Initialisierung nur eine ausgeführt wird,
- daß zum Abändern der Initialisierungsroutine die nicht ausgeführte Initialisierungsroutine überschrieben wird und
- daß nach dem Überschreiben der nicht ausgeführten Initialisierungsroutine bei einer erneuten Initialisierung diese Initialisierungsroutine ausgeführt wird.

10. Verfahren nach Anspruch 8 oder 9, **dadurch gekennzeichnet,** daß Änderungen blockweise an das Rechengerät (1,1') übertragen werden, und daß der Inhalt des Festwertspeichers (6) überschrieben wird, wenn dem Rechengerät (1,1') aufgrund eines Sonderbefehls eine Änderungsanforderung übermittelt wird.

11. Verfahren nach Anspruch 10, **dadurch gekennzeichnet,** daß in der Initalisierungsroutine und in den Änderungsblöcken jeweils mindestens eine Kennung abgespeichert ist, daß die Kennungen vor einem Änderungsvorgang miteinander verglichen werden und daß bei unzulässigen Kennungskombinationen der Änderungsvorgang unterdrückt wird.

## Claims

1. A read-only memory (6) with an electrical overwrite capability, in particular a ROM (6) which can be rapidly erased in an integrated manner, with a plurality of memory cells, each memory cell having an address on the basis of which the memory cell can be individually written and read, and with contacts for the connection of lines for address signals (A16...A0) , data signals (D7...D0) and control signals (WR, CS, GND, V_{CC}, V_{PP}, invert, select V_{Boot}, CL_{B}, CL_{M}), wherein the read-only memory (6) has at least two memory areas (B0, B1) which can be separately written and read and optionally also separately erased and to which the memory cells are assigned, characterised in that the memory cells of the at least two memory areas which can be separately written and read have identical addresses (0 to 2¹²-1) and that as a function of a first status variable, either the memory cells of a first of the memory areas (B0) or the memory cells of a second of the memory areas (B1) can be accessed.

2. A read-only memory (6) according to Claim 1, characterised in that the memory cells of the respective other memory area (B1) can be accessed only when special control signals (V_{Boot}) are present.

3. A read-only memory (6) according to Claim 1 or 2, characterised in that it has an additional memory area (M) for the storage of further data.

4. A read-only memory (6) according to Claim 1, 2 or 3, characterised in that as a function of a second status variable (I), before the assignment of a memory cell to the applied address signals (A16...A0) at least one of the address signals (A16...A0) is inverted.

5. A read-only memory (6) according to Claim 1, 2, 3 or 4, characterised in that the read-only memory (1) has at least one further memory area (flags) for the storage of the first and second status variables (S, I).

6. A read-only memory (6) according to Claim 5, characterised in that the further memory area (flags) can be accessed only when special control signals (V_{boot}) are present.

7. A read-only memory (6) according to one of Claims 1 to 6, characterised in that it is used in a computer (1, 1'), for example a programmable controller (1), for the storage of at least the initialisation routine.

8. A process for the modification of the initialisation routine of a computer stored in a read-only memory (6) according to one of Claims 1 to 7, characterised by the following steps:
a) a special control signal (V_{Boot}) is applied to the read-only memory (6), which control signal facilitates the overwriting of the content of the ready-only memory (6) where, for such time as the special signal is applied, as a function of the first status variable (S) the first or second memory area (B0) is not accessed at all whereas the second or first memory area (B1) can be accessed both for the purpose of reading and writing and optionally also for the purpose of erasing,
b) if the read-only memory (6) is a ROM (6) which can be rapidly erased in an integrated manner, a further control signal (CL_{B}) is applied to the read-only memory (6), by means of which further control signal, as a function of the first status variable (S), the first or second memory area (B0, B1), in which the initialisation routine is stored, is erased,
c) as a result of the application of address signals (A16...A0) and data signals (D7...DO) and optionally further control signals (WR, CS), the contents of the memory cells, selected on the basis of the applied address signals (A16...A0), of the first or second of the memory areas are overwritten with a memory content determined by the applied data signals (D7...D0),
d) following the overwriting of the memory content of the read-only memory (6), the first status variable (S) is inverted and the special control signal (V_{Boot}) is reset.

9. A process according to Claim 8, characterised in that
- the computer (1, 1') has two initialisation routines of which only one is executed in the case of an initialisation,
- for the modification of the initialisation routine, the initialisation routine which is not executed is overwritten and
- following the overwriting of the initialisation routine which is not executed, this initialisation routine is executed in a new initialisation.

10. A process according to Claim 8 or 9, characterised in that modifications are transmitted block by block to the computer (1, 1') and that the content of the read-only memory (6) is overwritten when a modification request is communicated to the computer (1, 1') as a result of a special command.

11. A process according to Claim 10, characterised in that in each case at least one identification is stored in the initialisation routine and in the modification blocks, the identifications are compared with one another prior to a modification operation and in the case of impermissible identification combinations the modification operation is suppressed.

## Revendications

1. Mémoire morte programmable, effaçable électriquement (6), notamment mémoire morte (6) rapidement effaçable en bloc, comportant plusieurs cellules de mémoire, chaque cellule de mémoire ayant une adresse sur la base de laquelle la cellule de mémoire peut être écrite et lue individuellement, et des contacts pour le raccordement de lignes pour des signaux d'adresses (A16 à A0), pour des signaux de données (D7 à D0) et pour des signaux de commande (WR, CS, GND, V_{CC}, V_{PP}, invert, select, V_{boot}, CL_{B}, CL_{M}), la mémoire morte (6) comportant au moins deux zones de mémoire (B0, B1) qui peuvent être écrites et lues séparément et aussi effacées séparément le cas échéant et auxquelles les cellules de mémoire sont associées, caractérisée par le fait que les cellules de mémoire des - au moins deux - zones de mémoire pouvant être lues et écrites séparément ont des adresses identiques (0 à 2¹²-1) et qu'on peut accéder, en fonction d'une première grandeur d'état (S), soit aux cellules de mémoire de la première des zones de mémoire (B0) soit aux cellules de mémoire de la deuxième des zones de mémoire (B1).

2. Mémoire morte (6) selon la revendication 1, caractérisée par le fait que l'on ne peut accéder aux cellules de mémoire de l'autre zone de mémoire (B1) respective qu'en présence de signaux de commande (V_{boot}) particuliers.

3. Mémoire morte (6) selon la revendication 1 ou 2, caractérisée par le fait qu'elle comporte une zone de mémoire (M) supplémentaire pour la mémorisation d'autres données.

4. Mémoire morte (6) selon la revendication 1, 2 ou 3, caractérisée par le fait que, en fonction d'une deuxième grandeur d'état (I), au moins l'un des signaux d'adresses (A16 à A0) est inversé avant l'association d'une cellule de mémoire aux signaux d'adresses (A16 à A0) appliqués.

5. Mémoire morte (6) selon la revendication 1, 2, 3 ou 4, caractérisée par le fait que la mémoire morte (1) comporte au moins une autre zone de mémoire (Flags) pour la mémorisation de la première et de la deuxième grandeur d'état (S, I).

6. Mémoire morte (6) selon la revendication 5, caractérisée par le fait que l'on ne peut accéder à l'autre zone de mémoire (Flags) qu'en présence de signaux de commande (V_{boot}) particuliers.

7. Mémoire morte (6) selon l'une des revendications 1 à 6, caractérisée par le fait qu'elle est utilisée dans un ordinateur (1, 1'), par exemple un appareil d'automatisation (1), pour mémoriser au moins la routine d'initialisation.

8. Procédé pour le changement de la routine d'initialisation d'un ordinateur qui est mémorisée dans une mémoire morte (6) selon l'une des revendications 1 à 7, caractérisé par les étapes suivantes :
a) on applique à la mémoire morte (6) un signal de commande (V_{boot}) particulier qui permet une réécriture du contenu de la mémoire morte (6), sachant que, tant que le signal particulier est appliqué, on n'accède pas du tout en fonction de la première grandeur d'état (S) à la première, respectivement à la deuxième, zone de mémoire (B0) tandis qu'on peut accéder à la deuxième, respectivement à la première, zone de mémoire (B1) aussi bien en lecture qu'en écriture et qu'en effacement le cas échéant,
b) si la mémoire morte (6) est une mémoire morte (6) rapidement effaçable en bloc, on applique à la mémoire morte (6) un autre signal de commande (CL_{B}) par lequel, en fonction de la première grandeur d'état (S), la première ou la deuxième zone de mémoire (B0, B1), dans laquelle la routine d'initialisation est mémorisée, est effacée,
c) en appliquant des signaux d'adresses (A16 à A0) et des signaux de données (D7 à D0) et éventuellement d'autres signaux de commande (WR, CS), on réécrit le contenu des cellules de mémoire, qui sont sélectionnées sur la base des signaux d'adresses (A16 à A0) appliqués, de la première ou de la deuxième zone de mémoire avec un contenu de mémoire qui est déterminé par les signaux de données (D7 à D0) appliqués,
d) après la réécriture du contenu de la mémoire morte (6), on inverse la première grandeur d'état (S) et on remet à l'état initial le signal de commande (V_{boot}) particulier.

9. Procédé selon la revendication 8, caractérisé par le fait que
- l'ordinateur (1, 1') comporte deux routines d'initialisation parmi lesquelles une seule est exécutée lors d'une initialisation,
- pour changer la routine d'initialisation, on réécrit sur la routine d'initialisation non exécutée et
- après la réécriture sur la routine d'initialisation non exécutée, on exécute lors d'une nouvelle initialisation cette routine d'initialisation.

10. Procédé selon la revendication 8 ou 9, caractérisé par le fait que l'on transmet des changements par blocs à l'ordinateur (1, 1') et que l'on réécrit le contenu de la mémoire morte (6) lorsqu'une demande de changement est transmise à l'ordinateur (1, 1') en raison d'une instruction particulière.

11. Procédé selon la revendication 10, caractérisé par le fait que l'on mémorise dans la routine d'initialisation et dans les blocs de changement à chaque fois au moins un identificateur, que l'on compare entre eux les identificateurs avant une opération de changement et que l'on empêche l'opération de changement en présence de combinaisons inadmissibles d'identificateurs.
